**Europäisches Patentamt**

**European Patent Office**

**Office européen des brevets**

(11) Publication number: **0 112 899**
**B1**

(12) EUROPEAN PATENT SPECIFICATION

(45) Date of publication of patent specification: **18.10.89**

(21) Application number: **83902372.8**

(22) Date of filing: **16.06.83**

(86) International application number:
**PCT/US83/00951**

(87) International publication number:
**WO 84/00445 02.02.84 Gazette 84/03**

(51) Int. Cl.⁴: **H 01 R 4/02**

(54) **SOLDER BEARING TERMINAL PIN.**

(30) Priority: **09.07.82 US 396764**

(43) Date of publication of application:
**11.07.84 Bulletin 84/28**

(45) Publication of the grant of the patent:
**18.10.89 Bulletin 89/42**

(84) Designated Contracting States:
**AT BE CH DE FR GB LI LU NL SE**

(56) References cited:
**EP-A-0 005 356**
**US-A-3 864 014**
**US-A-3 915 546**
**US-A-4 193 654**
**US-A-4 203 648**
**US-A-4 286 837**
**US-A-4 302 067**

(73) Proprietor: **NORTH AMERICAN SPECIALITIES CORP.**
**120-12 28th Avenue**
**Flushing New York 11354 (US)**

(72) Inventor: **SEIDLER, Jack**
**29-34 146th Street**
**Flushing, NY 11354 (US)**

(74) Representative: **Pritchard, Colin Hubert et al**
**Mathys & Squire 10 Fleet Street**
**London EC4Y 1AY (GB)**

Courier Press, Leamington Spa, England.

## Description

Background of the Invention

This invention relates to a solder bearing terminal pin for attachment to a receptacle in a substrate wherein a discreet mass of solder is mechanically held by the terminal in position to be melted for connecting the terminal to the receptacle with both an electrical and mechanical bond.

The terminal is of a type which is capable of being continuously stamped from a thin sheet of metal at high speed, and because each terminal pin mechanically holds its own discrete mass of solder, the pins may be produced individually or, preferably, attached to a common carrier strip for automated, machine insertion into the receptacle in the substrate.

Various means have been provided wherein a quantity of solder is associated with a terminal pin so that when the terminal is inserted into a receptacle in a substrate (usually a hole drilled through the substrate with a metal surface plated on its interior and on the surface of the substrate around the periphery of the hole) and the assembly is heated, the molten solder covers the adjacent surfaces of the terminal and receptacle to form, when cool, a soldered metallurgical joint between the terminal and receptacle.

In the prior art individual terminal pins were pressed into the receptacle in the substrate and soldering was accomplished by either passing the entire substrate over a solder wave machine or by applying solder to each individual terminal pin using a conventional soldering iron and wire solder.

An alternative method used in the prior art has associated the solder with each terminal pin by means of metallurgical bond between the solder and the pin wherein the solder was positioned in a location which was far removed from the receptacle in the substrate. This method suffered from the poor solder bond because the solder was required to migrate down the terminal pin before it could reach the junction between the terminal and the receptacle which was to be soldered.

It is an object of the present invention to provide means for attaching securely a discrete solder mass to a terminal pin in a purely mechanical manner.

It is a further object of the invention to provide a solder bearing terminal pin wherein each terminal has its own supply of solder in a convenient location for melting to form bonds with a receptacle.

It is another object of the invention to provide a solder and terminal pin assembly which can be made by very simple and efficient stamping steps.

According to the invention there is provided a terminal pin adapted to be soldered to a substrate having a conductive area. the pin comprising an elongated body portion and a finger extending outwardly from said body portion and having a curved portion, there being a partially enclosed space formed by an inner concave side of the finger with an opening to said space facing in a direction along said body portion. and said finger having a solderable portion adapted to be soldered to said conductive area, said solderable portion and said conductive area being opposed adjacent to one another when said pin and conductive area are mated; and a mass of solder carried by said pin within said space, at a position where, upon mating of said pin and said substrate, said solder mass is opposite said conductive area in direct confronting and unobstructed juxtaposition with said conductive area adjacent said solderable portion, with said finger removed from the space between said solder mass and said conductive area, whereby upon melting of said solder when said pin and substrate are mated said molten solder is positioned directly at said solderable portion and said conductive area so that on cooling said solder joins said pin and said conductive area electrically and mechanically.

The construction of the terminal pin in order to achieve good retention of the solder mass and a proper solder flow is achieved by a reversal of the conventional solder-retaining arrangements of the prior art. US-A-4.203.648 shows an edge clip for a circuit board wherein a solder mass is held by either a resilient end finger 26 or a central finger 27 bent around a solder mass 30. In both instances, the fingers are interposed between the solder and a contact pad on the substrate. This means that the finger partially blocks the access of solder to the contact pad, forcing reliance upon a capillary flow of solder between the finger and the body. As indicated above, this arrangement is reversed in a terminal pin according to the present invention, where care is taken to avoid having a finger between the solder and the contact body. The finger is removed from an interposed position, which is exactly the reverse of the prior art arrangement. Moreover, this arrangement overcomes a problem in prior art arrangements, namely, the need for good retention of a solder mass whilst still allowing a satisfactory flow of solder during the soldering operation.

The invention will now be described, by way of example, with reference to the accompanying drawings, wherein:-

Figure 1 represents the front elevational view of two terminal pins according to the invention attached to a common carrier strip;

Figure 2 represents a side view of the terminals shown in Figure 1;

Figure 3 represents a partial front elevational view of the terminal according to Figure 1 inserted into a receptacle prior to the application of heat;

Figure 4 shows the same partial front elevational view as Figure 3 after sufficient heat has been applied to cause the solder to flow and form a metallurgical joint;

Figure 5 represents a partial front elevational view of a first modified form of the terminal shown in Figure 3;

Figure 6 represents a partial front elevational view of a second modified form of the terminal shown in Figure 1;

Figure 7 represents a partial side view of the modified form shown in Figure 6;

Figure 8 represents the front elevational view of two terminal pins of a third modified form attached to two common carrier strips; and

Figure 9 represents a side view of the terminals shown in Figure 8.

Description of the Preferred Embodiments

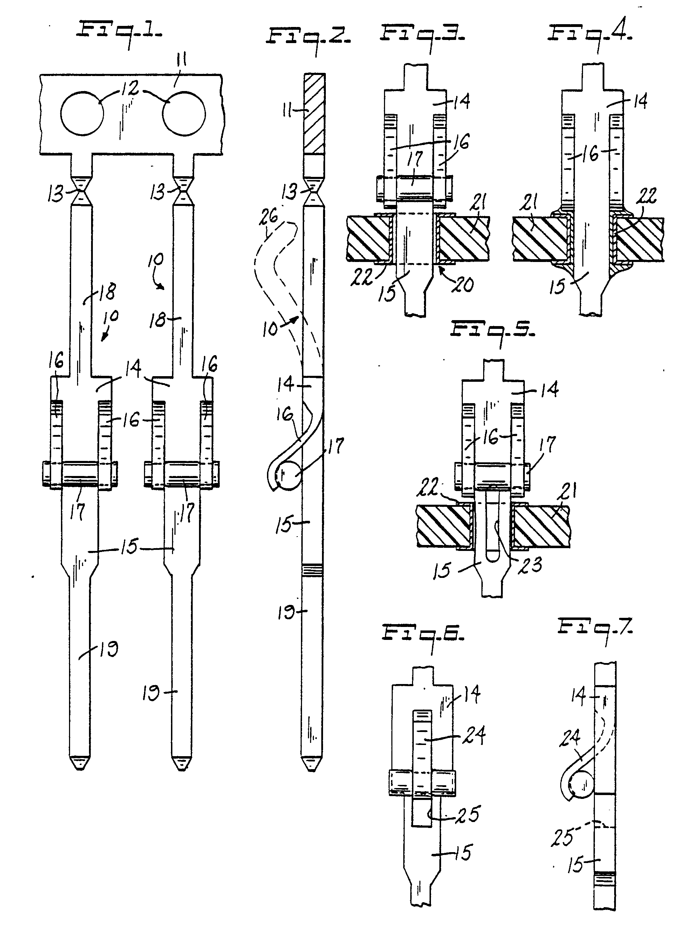

Referring to the drawings, Figure 1 shows two individual solder bearing terminal pins 10 connected to a common carrier strip 11. The carrier strip may be provided with pilot holes 12 at regular intervals, as is customary, and the terminal pins may be connected to the carrier strip via break-away notches 13 for removal of the carrier strip after the terminal pins have been soldered into position. Each terminal pin includes an upper body portion 14, and a lower body portion 15, two fingers 16, a discrete solder mass 17, an upper contact arm 18, and a lower contact arm 19.

The carrier strip 11 can be any length desired, carrying a great number of terminal pins. The terminal pins and carrier strip are preferably made by continuously stamping them from a thin sheet of metal, and during the stamping operation, the fingers 16 are bent out of the plane of the body of the terminal pin.

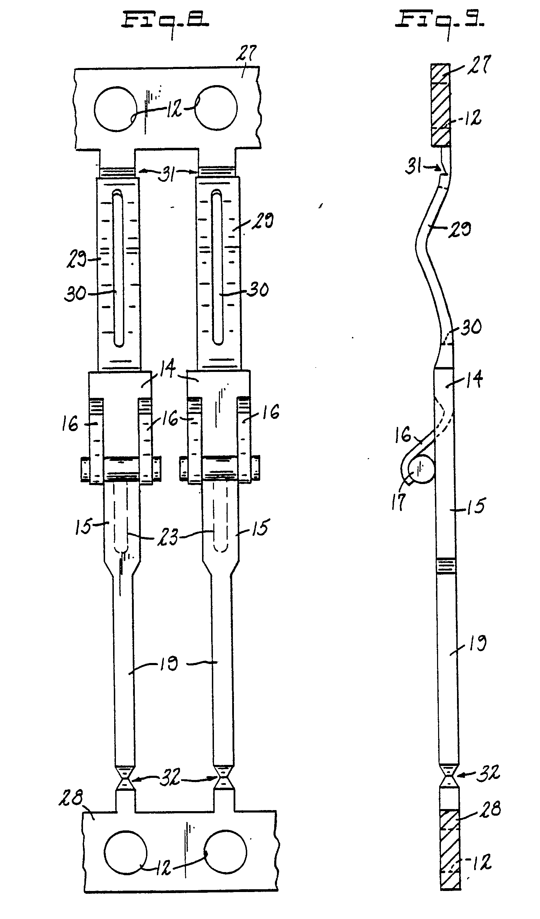

As shown in Figure 2, each finger 16 has a curved portion. A partially enclosed space is formed by an inner concave side of each finger 16 with an opening to this space facing in a direction along the body portion of the terminal pin i.e. downwardly in Figure 2.

The fingers 16 are wrapped partially around the discrete mass of solder 17, a lower end of each finger serving as a solderable portion. During the stamping operation, the fingers are preferably stamped to a thickness which is less than that of the body of the terminal pin. This allows the fingers 16 to be wrapped more readily around the discrete mass of solder 17. During the stamping operation, when the free ends of the fingers 16 are wrapped around the softer metal of the solder, the wrapping can be done with sufficient force to indent the fingers into the surface of the solder to provide a firm mechanical attachment between the solder and the terminal pin which prevents the solder from becoming dislodged during shipping and handling. prior to the completion of the soldering operation.

Referring to Figure 2, which is a side view of Figure 1, it can be seen that the fingers 16 are of a thickness which is less than the thickness of the body of the terminal pin. The thickness of the body portions 14 and 15 are, for convenience, usually but not necessarily, chosen to be of the same thickness as that of the upper and lower contact arms 18 and 19 respectively. This thickness may be adjusted during the stamping operation.

In use, the contact arms may be soldered to an adjacent printed circuit board, may have wires or other electrical components soldered to them, may serve as pin or blade connectors for an electrical plug, may have a wire or wires conventionally wire wrapped onto them, may function as spring contacts, or may have other electrical and mechanical connections where appropriate. The fingers 16 are preferably stamped from the same thin sheet material as the remainder of the pin, and the thickness of the fingers is reduced during the stamping operation, allowing them to be more easily formed into the appropriate shape.

Upper contact arm 18 may be of any suitable shape. If required, it may have a square cross section suitable for a wire wrapped connection, or a round cross section for a solder connection, and it may be straight or bent out of the plane of the terminal pin as indicated in the dashed lines 26 of Figure 2 to form a spring-like side contact arm. Lower contact arm 19 must be of a size such as to permit it to pass through the receptacle in the substrate which requires that its largest cross sectional dimension be no larger than the largest cross section dimension of the lower body portion 15. Lower contact arm 19 may be eliminated entirely where desired, as may upper contact arm 18. In the latter case, carrier strip 11 would be attached directly to the upper body portion 14.

Figure 1 illustrates the terminal pins connected to a carrier strip 11. While this is the preferred embodiment suitable for automated machine insertion into the substrate, it is also possible, due to the fact that each individual pin is firmly attached to its own solder mass, to use the pins individually as might be desired by the user of small quantities of pins. It is also possible to remove individual pins from the carrier strip without disturbing the remainder of the pins which allows a customized template of pins to be inserted as a unit into a corresponding template of receptacles in a substrate.

Figure 3 shows a detailed front view of the terminal pin in Figure 1 inserted into a receptacle 20 in a substrate 21 which has been coated with a contact material 22 in the vicinity of the receptacle and on its interior surface. It can be seen that the lower body portion 15 has been sized to closely fit the receptacle in the substrate, which provides a good electrical contact after soldering. The receptacle in Figure 3 consists of a hole drilled through the substrate 21 and plated through with a contact material 22.

Figure 3 also illustrates how the fingers 16 hold the solder in close proximity to the lower body portion 15 and the receptacle 20 prior to the application of heat and the completion of the soldering operation.

Figure 4 is a detailed view of the metallurgical joint formed between the terminal pin and the receptacle in the substrate after the pin and substrate have been heated sufficiently to melt the solder. It can be seen that the solder flows completely around the lower body portion 15, bonding the lower portion of the contact material on the substrate, the interior of the receptacle, and the lower, solderable portion of each finger 16 to the terminal pin.

Figure 5 shows a modified form of the terminal pin wherein a longitudinal slot 23 has been cut through the lower body portion 15. The longitudinal slot 23 and lower body portion 15 are correctly sized with respect to the thickness of the substrate 21 and the diameter of the receptacle 20 so that the lower body portion is slightly oversized with respect to the receptacle 20 prior to insertion, and a tight compressive fit is achieved after insertion. A pin which produces such a tight compressive fit is commonly known as a compliant pin. A compliant pin produces a temporary bond between the terminal pin and the receptacle which allows additional handling of the electrical assembly such as the insertion of other electrical components prior to soldering, without fear that the previously inserted terminal pins will become dislodged during the additional handling. The use of a longitudinal slot 23 to produce a compliant pin has an additional advantage of allowing the use of individual pins, not attached to a carrier strip which are extremely susceptible to dislodgement when disconnected from their carrier strip. A further advantage associated with the use of longitudinal slot 23 to provide a compliant pin is that the slot forms a flow channel for the molten solder to reach the underside of the substrate 21. This is especially important where the cross sectional shape of the lower contact pin 15 and the receptacle 20 are approximately identical, in which case the solder is prevented in the absence of a longitudinal slot 23 from reaching the lower surface. Longitudinal slot 23 also provides additional surface area to allow for a better mechanical and electrical bond between the lower body portion 15 and the receptacle 20.

Referring to Figure 6, the second modified form of the terminal pin is shown as having a single central finger 24 formed from a U-shaped longitudinal cut 25 along the axis of the body. The U-shaped longitudinal cut 25 can be extended down the axis of the lower body portion 15 to perform the same function as longitudinal slot 23 to provide a compliant pin.

Figure 7 is a side view of the second modified form shown in Figure 6. It can be seen in both Figures 2 and 7 that the engaging fingers 16 and 24 wrap partially around the mass of solder 17 holding it in the gap formed between the finger or fingers and the body of the terminal pin. The fingers wrap partially around the solder mass, and the solder mass may be of any suitable shape. It is of particular value to have the finger indent into the surface of the softer solder mass when only a single finger is used for attachment to prevent the solder from becoming disengaged from the terminal pin prior to the application of heat.

Figure 8 is a front elevational view of two terminal pins of a third modified form connected to two common carrier strips, an upper carrier strip 27 and a lower carrier strip 28, both of which are provided with the customary pilot holes 12. In this modified form the upper contact arm 29 is a cantilever spring blade contact with a central longitudinal slot 30 which provides additional spring action to the upper contact arm 29. The two common carrier strips, 27 and 28, provide additional rigidity for the attached terminal pins, which keeps them in accurate alignment during shipping and handling prior to their insertion into the receptacle.

Figure 9 is a side view of the third modified form shown in Figure 8. It can be seen in this view that the upper contact arm 29 has been stamped to a thickness which is less than that of the body of the terminal pin which provides additional spring action. An upper break-away notch 31 and lower break-away notch 32 can also be clearly seen in this figure.

In each of the terminal pins described above, the mass of solder is in mechanical engagement with the terminal fingers in position to be melted for the formation of a bond between the terminal fingers 16, the terminal body 14 and 15 and the receptacle 20 in the substrate 21. The solder mass may, if desired, have a cross section of circular, square or other geometrical form, or be made from spherical pellets.

Although Figure 8 has been drawn with two fingers 16, it is apparent that it can be constructed with a single central finger 24 as shown in Figures 6 and 7. It also can be constructed with or without a central longitudinal slot 30 or a longitudinal slot 23 as desired. Furthermore, a lower carrier strip 28 may be used in conjunction with any of the terminal pins shown and where such a lower carrier strip is used, the upper carrier strip is optional. Each terminal can also be made by simple stamping and assembling steps, with minimal waste of material.

It will thus be seen that the objects set forth above, among those made apparent from the preceeding description, are efficiently attained.

**Claims**

1. A terminal pin (10) adapted to be soldered to a substrate (21) having a conductive area (22), the pin (10) comprising an elongated body portion (14, 15) and a finger (16; 24) extending outwardly from said body portion (14, 15) and having a curved portion, there being a partially enclosed space formed by an inner concave side of the finger (16; 24) with an opening to said space facing in a direction along said body portion (14, 15), and said finger (16; 24) having a solderable portion adapted to be soldered to said conductive area (22), said solderable portion and said conductive area (22) being opposed adjacent to one another when said pin (10) and conductive area (22) are mated; and a mass of solder (17) carried by said pin (10) within said space, at a position where, upon mating of said pin (10) and said substrate (21), said solder mass (17) is opposite said conductive area (22) in direct confronting and unobstructed juxtaposition with said conductive area (22) adjacent said solderable portion, with said finger (16; 24) removed from the space between said solder mass (17) and said conductive area (22), whereby upon melting of said solder (17) when said pin (10) and substrate (21) are mated said molten solder (17) is positioned directly at said solderable portion and said conductive area (22) so that on cooling said solder (17) joins said pin (10) and said conductive area (22) electrically and mechanically.

2. A terminal pin as claimed in claim 1 which is adapted to be soldered to a conductive area on a substrate having a lead-receiving opening (20), wherein said elongated body portion (14, 15) has an upper body portion (14) and a lower body portion (15), said lower body portion (15) is sized to fit in said substrate opening (20) substantially perpendicular to said substrate (21), said body portion (14, 15) is cut longitudinally to define said finger (16; 24), said solder mass (17) is held between a free end of said finger (16; 24) and said body portion, said finger free end being wrapped only partially around said solder mass (17) to leave at least a portion of said solder mass (17) uncovered by said finger (16; 24).

3. A terminal pin as claimed in claim 2, wherein said body portion (14, 15) is also cut longitudinally along a second line to define a second finger (16), said fingers (16) being separated by said upper body portion (14), both of said fingers (16) being wrapped only partially around said solder mass (17).

4. A terminal pin as claimed in claim 2 or 3, further comprising at least one contact portion (18, 19; 29, 19) attached to said body portion (14, 15).

5. A terminal pin as claimed in claim 2, wherein said cut (25) in said body portion (14, 15) is substantially U-shaped to define said finger (24) centrally of and between spaced portions of said body portion (14, 15), said central finger being wrapped only partially around the said solder mass (17).

6. A terminal pin as claimed in claim 2, wherein the lower body portion (15) has a longitudinal slot (23) along its axis, the width of said slot (23) and said lower body portion providing a compressive fit between the lower body portion (15) and the opening (20) in the substrate (21).

7. A terminal pin as claimed in claim 2, wherein said finger (16; 24) is indented into the surface of the mass of solder (17) for holding the mass securely in position.

8. A terminal pin as claimed in claim 4, wherein said pin (10) has 8 an upper contact portion (1; 29) attached to and axially aligned with the upper body portion (14), and a lower contact portion (19; 19) attached to and axially aligned with the lower body portion (15), said lower contact portion (19; 19) being at least as small in its thickness and width as the lower body portion (15) to allow the lower contact portion to pass through the opening (20) in the substrate.

9. A terminal pin as claimed in claim 8, wherein the upper contact portion (29) is bent out of the plane of the body portion (14, 15) at approximately its point of attachment to the upper body portion (14), and bent reflexively back towards the plane of the body portion (14, 15) near the tip of the upper contact portion (29) providing a spring-like contact.

10. A terminal pin as claimed in claim 8, wherein the upper contact portion (29) comprises a spring-like blade contact with a central longitudinal slot (30).

11. A plurality of terminal pins as claimed in claim 4, wherein each pin (10) has an upper contact portion (18; 29) and a lower contact portion (19; 19) connected to said elongated body portion (14, 15), and the upper contact portion (18; 29) of each pin (10) is connected to an upper carrier strip (11; 27), and each lower contact portion is connected to a lower carrier strip (12).

12. A terminal pin as claimed in claim 8, wherein the lower body portion (15) has a longitudinal solder-flow channel opening (23) therein along its axis and extending from a point corresponding to a position above the upper surface of the substrate (21) to a point corresponding to a position below the lower surface of the substrate (21) when said lower body portion (15) is inserted into said receptacle (20), whereby said solder (17) may flow from the upper surface of said substrate (21) to the lower surface of said substrate (21).

13. In combination, a substrate (21) having a conductive area (22) and a terminal pin (10) as claimed in any one of the preceding claims for soldering to said conductive area, said opening to said space facing and directly juxtaposed to said conductive area (22) so that said space communicates with said conductive area.

14. A combination as claimed in claim 13, wherein said finger (16; 24) is at an end of said pin (10).

15. A method of mounting a terminal pin on a substrate comprising the steps of forming a terminal pin (10) as claimed in any one of claims 1 to 12, placing said solder mass (17) in said opening to said space, juxtaposing said opening directly to and confronting said substrate conductive area (22), and melting said solder (17) to join said pin portion (15) to said conductive area (22).

**Patentansprüche**

1. Lottragende Endklemme (10) zum Anlöten an einem Substrat (21) mit einem leitenden Bereich (22), welche Endklemme (10) einen langgestreckten Klemmenteil (14, 15) und einen Finger (16; 24) aufweist, der nach außen von dem Klemmenteil (14, 15) vorsteht und einen gewölbten Teil aufweist, wobei ein teilweise umschlossender Raum durch eine innen konkave Seite des Fingers (16; 24) mit einer Öffnung ausgebildet ist, die in Richtung entlang des Klemmenteils (14, 15) weist, und wobei der Finger (16; 24) einen lötbaren Teil hat, welcher mit dem leitenden Bereich (22) zu verlöten ist und der lötbare Teil sowie der leitende Bereich (22) einander gegenüberliegen, wenn die Klemme (10) und der leitende Bereich (22) ineinandergepaßt sind, und mit einer Lötmasse (17), welche an der Klemme (10) in dem Raum an einer Stelle getragen ist, an welcher bei Zusammenbringen der Klemme (10) und des Substrats (21) die Lötmasse (17) dem leitenden Bereich (22) unmittelbar und ungehindert gegenüberliegt, wobei der Finger (16; 24) aus dem Raum zwischen der Lötmasse (17) und dem leitenden Bereich (22) entfernt ist, so daß bei Schmelzen des Lots (17), wenn die Klemme (10) in das Substrat (21) eingeführt ist, das geschmolzene Lot (17) unmittelbar an dem verlötbaren Teil und dem leitenden Bereich (22) angeordnet ist, so daß nach einem Abkühlen das Lot (17) sich mit der Klemme (10) und demleitenden Bereich (22) elektrisch und mechanisch verbindet.

2. Lottragende Endklemme nach Anspruch 1, welche mit einem leitenden Bereich eines Substrats mit einer Aufnahmeöffnung (22) zu verlöten ist, wobei der langgestreckte Klemmenteil (14, 15) einen oberen Teil (14) und einen unteren Teil (15) aufweist, der untere Teil (15) so bemessen ist, daß er in die Substratöffnung (22) im wesentlichen senkrecht zu dem Substrat (21) paßt, der Klemmenteil (14, 15) in Längsrichtung geschnitten ist, um den Finger (16; 24) festzulegen, die Lötmasse (17) zwischen einem freien Ende des Fingers (16; 24) und dem Klemmenteil gehalten ist, wobei das freie Fingerende nur teilweise um die Lötmasse (17) gelegt ist, um zumindest einen Teil der Lötmasse (17) von dem Finger (16; 24) unbedeckt zu lassen.

3. Lottragende Endklemme nach Anspruch 2, bei welcher der Klemmenteil (14, 15) in Längsrichtung auch entlang einer zweiten Linie geschnitten ist, um zweite Finger (16) festzulegen, wobei die Finger (16) von dem oberen Klemmenteil (14) getrennt sind und beide (16) nur teilweise um die Lötmasse (17) gelegt sind.

4. Lottragende Endklemme nach einem der Ansprüche 2 oder 3, welcher zumindest einen Kontaktteil (18, 19; 29, 19), welcher an dem Klemmenteil (14, 15) angebracht ist, aufweist.

5. Lottragende Endklemme nach Anspruch 2, bei welcher der Einschnitt (25) in dem Klemmenteil (14, 15) im wesentlichen Uförmig ist, um den Finger (24) mittig von und zwischen im Abstand voneinander angeordneten Teilen des Klemmenteils (14, 15) festzulegen, wobei der mittige Finger nur teilweise um die Lötmasse (17) gelegt ist.

6. Lottragende Endklemme nach Anspruch 2, bei welcher der untere Klemmenteil (15) einen Längsschlitz (23) entlang seiner Längsachse hat, die Breite des Schlitzes (23) und der untere Klemmenteil einen Paßsitz zwischen dem unteren Klemmenteil (15) und der Öffnung (20) in dem Substrat (21) schaffen.

7. Lottragende Endklemme nach Anspruch 2, bei welcher der Finger (16; 24) in die Oberfläche der Lötmasse (17) eingedrückt ist, um die Masse sicher in einer vorgegebenen Lage zu halten.

8. Lottragende Endklemme nach Anspruch 4, bei welcher die Endklemme (10) einen oberen Kontaktteil (18; 29), welcher an dem oberen Klemmenteil (14) angebracht und axial zu diesem ausgerichtet ist, und einen unteren Kontaktteil (19; 19) hat welcher an dem unteren Klemmenteil (15) angebracht und axial zu diesem ausgerichtet ist, wobei der untere Kontaktteil (19; 19) zumindest so klein in Dicke und Breite wie der untere Klemmenteil (15) ist, um den unteren Kontaktteil durch die Öffnung (20) in dem Substrat (21) hindurchführen zu können.

9. Lottragende Endklemme nach Anspruch 8, bei welcher der obere Kontaktteil (29) aus der Ebene des Klemmenteils (14, 15) etwa an der Halterungsstelle an dem oberen Klemmenteil (14) herausgebogen und spiegelbildlich zurück in Richtung der Ebene des Klemmenteils (14, 15) nahe dem vorderen Ende des oberen Kontaktteils (29) gebogen ist, wodurch ein federartiger Kontakt geschaffen ist.

10. Lottragende Endklemme nach Anspruch 8, bei welcher der obere Kontaktteil (29) einen federartigen Blattkontakt mit einem mittigen Längsschlitz (30) aufweist.

11. Eine Anzahl lottragender Endklemmen nach Anspruch 4, bei welcher jede Endklemme (10) einen oberen Kontaktteil (18; 19) und einen unteren Kontaktteil (19; 19) aufweist, welcher mit dem langgestreckten Klemmenteil (14, 15) verbunden ist, und der obere Kontaktteil (18; 29) jeder Endklemme (10) mit einem oberen Trägerstreifen (11; 27) und jeder untere Kontaktteil mit einem unteren Trägerstreifen (12) verbunden ist.

12. Lottragende Endklemme nach Anspruch 8, bei welcher der untere Klemmenteil (15) eine in Längsrichtung verlaufende Lotflußöffnung (23) aufweist, die entlang dessen Achse verläuft und sich von einer Stelle, die einer Position über der oberen Fläche des Substrats (21) entspricht, bis zu einer Strecke erstreckt, welche einer Position unter der unteren Fläche des Substrats (21) entspricht, wenn der untere Klemmenteil (15) in die Öffnung (20) eingebracht ist, wobei das Lot (17) von der oberen Fläche des Substrats (21) zu der unteren Fläche des Substrats (21) fließen kann.

13. Substrat (21) mit einem leitenden Bereich (22) und eine lottragende Endklemme (10), wie sie in einer der vorherigen Ansprüche beansprucht ist, zum Verlöten mit dem leitenden Bereich, wobei die Öffnung in dem Raum dem leitenden Bereich (22) gegenüberliegt und unmittelbar bei diesem angeordnet ist, so daß der Raum mit dem leitenden Bereich in Verbindung steht.

14. Kombination nach Anspruch 13, bei welcher sich der Finger (16; 24) an einem Ende der Endklemme (10) befindet.

15. Verfahren zum Anbringen einer lottragenden Endklemme an einem Substrat, dadurch gekennzeichnet, daß eine solche Endklemme (10), wie sie in einem der Ansprüche 1 bis 12 beansprucht ist, erzeugt wird, die Lötmasse (17) in die Öffnung bei dem Raum eingebracht wird, die Öffnung unmittelbar bei und gegenüber dem leitenden Substratbereich (22) angeordnet wird, und das Lot (17) geschmolzen wird, um den Klemmenteil (15) mit dem leitenden Bereich (22) zu verbinden.

## Revendications

1. Broche à borne (10) prévue pour être soudée à un substrat (21) comportant une région conductrice (22), la broche (10) comprenant une partie de corps allongée (14, 15) et un doigt (16; 24) qui s'étend vers l'extérieur à partir de ladite partie de corps (14, 15) et présente une partie courbe, un espace partiellement fermé étant défini par un côté intérieur concave du doigt (16; 24) avec une entrée audit espace tournée dans une direction le long de ladite partie de corps (14, 15), et ledit doigt (16; 24) ayant une partie soudable prévue pour être soudée à ladite région conductrice (22), ladite partie soudable et ladite région conductrice (22) étant mutuellement opposées et adjacentes lorsque ladite broche (10) et la dite région conductrice (22) sont accouplées; et une masse de matière de soudage (17) portée par ladite broche (10) à l'intérieur dudit espace à un endroit où, lors de l'accouplement de ladite broche (10) et dudit substrat (21), ladite masse de matière de soudage (17) est en face de ladite région conductrice (22) en juxtaposition libre et directement en regard avec ladite région conductrice (22) adjacente à ladite partie soudable, ledit doigt (16; 24) étant éloigné de l'espace entre ladite masse de matière de soudage (17) et ladite région conductrice (22), de sorte que, lors de la fusion de ladite matière de soudage (17) lorsque ladite broche (10) et ledit substrat (21) sont accouplés, ladite matière de soudage fondue (17) est placée directement à l'endroit de ladite partie soudable et de ladite région conductrice (22), afin qu'après refroidissement ladite matière de soudage (17) relie ladite broche (10) et ladite région conductrice (22) électriquement et mécaniquement.

2. Broche à borne suivant la revendication 1, qui est prévue pour être soudée à une région conductrice sur un substrat comportant un trou de réception de conducteur (20), dans laquelle ladite partie de corps allongée (14, 15) comprend une partie supérieure de corps (14) et une partie inférieure de corps (15), ladite partie inférieure de corps (15) est dimensionnée pour s'ajuster dans ledit trou (20) du substrat sensiblement perpendiculairement audit substrat (21), ladite partie de corps (14, 15) est découpée longitudinalement pour définir le dit doigt (16; 24), ladite masse de matière de soudage (17) est tenue entre une extrémité libre dudit doigt (16; 24) et ladite partie de corps, ladite extrémité libre du doigt étant enroulée seulement partiellement autour de ladite masse de matière de soudage (17) pour laisser au moins une partie de ladite masse de matière de soudage (17) non couverte par ledit doigt (16; 24).

3. Broche à borne suivant la revendication 2, dans laquelle ladite partie de corps (14, 15) est également coupée longitudinalement le long d'une deuxième ligne pour définir un deuxième doigt (16), lesdits doigts (16) étant séparés par ladite partie supérieure de corps (14), les deux doigts (16) étant enroulés seulement partiellement autour de ladite masse de matière de soudage (17).

4. Broche à borne suivant la revendication 2 ou 3, comprenant en outre au moins une partie de contact (18, 19; 29, 19) attachée à ladite partie de corps (14, 15).

5. Broche à borne suivant la revendication 2, dans laquelle ladite découpe (25) dans ladite partie de corps (14, 15) est sensiblement en forme de U pour définir ledit doigt (24) au milieu et entre des parties espacées de ladite partie de corps (14, 15), ledit doigt central étant enroulé seulement partiellement autour de ladite masse de matière de soudage (17).

6. Broche à borne suivant la revendication 2, dans laquelle la partie inférieure de corps (15) comporte une fente longitudinale (23) le long de son axe, la largeur de ladite fente (23) et de ladite partie inférieure de corps engendrant un ajustement à compression entre la partie inférieure de corps (15) et le trou (20) du substrat (21).

7. Broche à borne suivant la revendication 2, dans laquelle ledit doigt (16; 24) s'encastre dans la surface de la masse de matière de soudage (17) pour tenir la masse solidement en position.

8. Broche à borne suivant la revendication 4, dans laquelle ladite broche (10) comprend une partie supérieure de contact (18; 29) attachée à la partie supérieure de corps (14) et axialement alignée avec celle-ci, et une partie inférieure de contact (19; 19) attachée à la partie inférieure de corps (15) et axialement alignée avec celle-ci, ladite partie inférieure de contact (19; 19) étant au moins aussi petite, en épaisseur et en largeur, que la partie inférieure de corps (15), pour permettre à la partie inférieure de contact de traverser le trou (20) du substrat.

9. Broche à borne suivant la revendication 8, dans laquelle la partie supérieure de contact (29) est pliée en dehors du plan de la partie de corps (14, 15) sensiblement à son point de fixation à la partie supérieure de corps (14), et pliée en sens inverse en retour vers le plan de la partie de corps (14, 15) près de l'extrémité libre de la partie supérieure de contact (29), pour constituer un contact élastique.

10. Broche à borne suivant la revendication 8, dans laquelle la partie supérieure de contact (29) comprend un contact à lame élastique comportant une fente longitudinale centrale (30).

11. Pluralité de broches à borne suivant la revendication 4, dans laquelle chaque broche (10) comprend une partie supérieure de contact (18; 29) et une partie inférieure de contact (19; 19) raccordées à ladite partie de corps allongée (14, 15), et la partie supérieure de contact (18; 29) de chaque broche (10) est connectée à une barrette porteuse supérieure (11; 27) et chaque partie inférieure de contact est connectée à une barrette porteuse inférieure (12).

12. Broche à borne suivant la revendication 8, dans laquelle la partie inférieure de corps (15) comporte un canal longitudinal d'écoulement de matière de soudage (23) ouvert dans cette partie le long de son axe et s'étendant à partir d'un point correspondant à une position au-dessus de la surface supérieure du substrat (21) jusqu'à un point correspondant à une position audessous de la surface inférieure du substrat (21) lorsque ladite partie inférieure de corps (15) est insérée dans ledit réceptacle (20), de sorte que ladite matière de soudage (17) peut s'écouler de la surface supérieure dudit substrat (21) jusqu'à la surface inférieure dudit substrat (21).

13. En combinaison, un substrat (21) comportant une région conductrice (22) et une broche à borne (10) suivant l'une quelconque des revendications précédentes pour soudage à ladite région conductrice, ladite entrée audit espace étant en regard et directement juxtaposée à ladite région conductrice (22) de sorte que ledit espace communique avec ladite région conductrice.

14. Combinaison suivant la revendication 13, dans laquelle ledit doigt (16; 24) est à une extrémité de ladite broche (10).

15. Procédé de montage d'une broche à borne sur un substrat, comprenant des opérations de formage d'une broche à borne (10) suivant l'une quelconque des revendications 1 à 12, de mise en place de ladite masse de matière de soudage (17) dans ladite entrée audit espace, de juxtaposition de ladite entrée directement à ladite région conductrice (22) du substrat et en face de cette région, et de fusion de ladite matière de soudage (17) pour joindre ladite partie de broche (15) à ladite région conductrice (22).

Fig.1.  Fig.2.  Fig.3.  Fig.4.  Fig.5.  Fig.6.  Fig.7.

Fig.8.

Fig.9.